# EUROPÄISCHE PATENTSCHRIFT

(11) **EP 1 008 075 B1**
(45) Veröffentlichungstag und Bekanntmachung des Hinweises auf die Patenterteilung: **02.04.2003**
(21) Anmeldenummer: 97949880.5
(22) Anmeldetag: 07.11.1997
(51) Int. Cl.: G06F 17/60

(54) **RECHNERGESTÜTZTES VERFAHREN ZUR PARTITIONIERUNG EINER ELEKTRISCHEN SCHALTUNG**
COMPUTER ASSISTED METHOD FOR PARTITIONING AN ELECTRIC CIRCUIT
PROCEDE ASSISTE PAR ORDINATEUR DE PARTITIONNEMENT D'UN CIRCUIT ELECTRIQUE

(30) Priorität: 18.11.1996 DE 19647622
(43) Veröffentlichungstag der Anmeldung: 14.06.2000
(73) Patentinhaber: Infineon Technologies AG, 81669 München (DE)
(72) Erfinder: WEVER, Utz, D-81539 München (DE); ZHENG, Qinghua, D-82024 Taufkirchen (DE)
(74) Vertreter: Reinhard - Skuhra - Weise & Partner
(86) Internationale Anmeldenummer: DE9702600
(87) Internationale Veröffentlichungsnummer: WO98024039

(56) Entgegenhaltungen:
- B. RIESS ET AL: "Partitioning Very Large Circuits Using Analytical Placement Techniques" PROCEEDINGS OF THE 31ST ACM/IEEE DESIGN AUTOMATION CONFERENCE, 6.Juni 1994, Seiten 646-651, XP000489051 in der Anmeldung erwähnt
- T. KAGE ET AL: "A Circuit Partitioning Approach for Parallel Circuit Simulation" IEICE TRANSACTIONS ON FUNDAMENTALS OF ELECTRONICS, COMMUNICATIONS AND COMPUTER SCIENCES, Bd. E77-A, Nr. 3, März 1994, TOKYO, JP, Seiten 461-465, XP000450882
- G.-G. HUNG ET AL: "Improving the Performance of Parallel Relaxation-Based Circuit Simulators" IEEE TRANSACTIONS ON COMPUTER-AIDED DESIGN OF INTEGRATED CIRCUITS AND SYSTEMS, Bd. 12, Nr. 11, November 1993, NEW YORK, US, Seiten 1762-1774, XP000450933
- J. LI ET AL: "New Spectral Linear Placement and Clustering Approach" 33RD DESIGN AUTOMATION CONFERENCE, 3. - 7.Juli 1996, LAS VEGAS, NV, US, Seiten 88-93, XP002058127
- F. M. JOHANNES: "Partitioning of VLSI Circuits and Systems" 33RD DESIGN AUTOMATION CONFERENCE, 3. - 7.Juli 1996, LAS VEGAS, NV, US, Seiten 83-87, XP002058192 in der Anmeldung erwähnt

## Beschreibung

Bei der Schaltungssimulation sehr großer Schaltungen, d.h. von Schaltungen mit einer sehr großen Anzahl von Elementen ist eine serielle Bearbeitung, d.h. Ermittlung der Schaltungsgrößen durch einen Rechner sehr zeitaufwendig. Selbst Vektorrechner, die in ihrem Betrieb sehr teuer sind, benötigen einen immensen Bedarf an Rechenkapazität und Zeit zur Ermittlung der elektrischen Beschreibungsgrößen für eine Schaltung, die einige 100.000 Transistoren aufweist.

Zur Vermeidung der seriellen Durchführung einer Schaltungssimulation kann aus diesem Grunde die elektrische Schaltung in mehrere Teile aufgeteilt werden, die dann jeweils von verschiedenen Rechnern bzw. Prozessoren bearbeitet werden, was zu einer parallelen Durchführung der Schaltungssimulation führt.

IEICE TRANSACTIONS ON FUNDAMENTALS OF ELECTRONICS, COMMUNICATIONS AND COMPUTER SCIENCES, T. Kage et al.: "A circuit partitioning approach for parallel circuit simulation" Bd. E77-A, Nr.3, März 1994, Tokyo, JP, Seiten 461-465, XP 000450882 zeigt beispielsweise ein Verfahren zur Partitionierung von elektrischen Schaltungen welches aus folgenden Schritten besteht:
a) Das Gruppieren von Transistoren, Kondensatoren und Widerständen in sog. Transistorgruppen.
b) Das Zusammenfassen von mehreren Transistorgruppen in sog. Schaltungsblocks.
c) Minimieren von Verbindungen zwischen den Schaltungsblöcken durch Verschieben von Transistorgruppen.
d) Nivellierung der Anzahl der Transistorgruppen in den Schaltungsblöcken.

Um jedoch eine möglichst gute Parallelisierbarkeit der Ermittlung der elektrischen Beschreibungsgrößen für die Elektroschaltung zu erreichen, ist es vorteilhaft, folgende zwei Kriterien bei der Partitionierung der elektrischen Schaltung in mehrere Teile zu beachten. Es ist von erheblicher Bedeutung, daß alle gebildeten Partitionen der elektrischen Schaltung möglichst gleich groß sind, um dadurch den durch die Parallelisierung erzielbaren Effekt zu verstärken. Ist beispielsweise eine Partition um Größenordnungen größer als die restlichen Partitionen, so ist die Bearbeitung der wesentlich größeren Partition wiederum sehr viel rechenaufwendiger als die Bearbeitung der restlichen Partitionen. Ferner ist es bei der Partitionierung wichtig, daß zwischen den einzelnen Partitionen möglichst nur eine geringe Anzahl von Verbindungen besteht, da bei den bekannten Verfahren zur "parellelisierten" Schaltungssimulation die benötigte Übertragungskapazität, d.h. die erforderliche Kommunikation zwischen den Rechner bzw. Prozessoren, die jeweils eine Partition bearbeiten, erheblich steigt mit steigender Anzahl von bestehenden Verbindungen zwischen den Partitionen.

Eine Sprache zur textuellen Beschreibung einer elektrischen Schaltung, welche durch einen Rechner verarbeitet werden kann, ist aus dem Dokument [1] als Schaltungssimulationssprache SPICE bekannt.

In den Dokumenten [2] und [3] ist beschrieben, wie eine parallelisierte Schaltungssimulation durchgeführt werden kann, vorausgesetzt, es liegt eine beliebige Anzahl von Partitionen der elektrischen Schaltung vor. Die Art und Weise, wie die Partitionen ermittelt werden können, wird in diesen Dokumenten nicht beschrieben.

Aus dem Dokument [4] ist ein globales Partitionierungsverfahren auf der sogenannten Logikebene, welche auch als Gatterebene bezeichnet wird, bekannt.

Auf der Logikebene werden diskrete Ereignisse beschrieben, mit denen jedoch keine stetigen dynamischen Eigenschaften einer elektrischen Schaltung auf der sogenannten Transistorebene, also auf der eigentlich physikalischen Ebene der elektrischen Schaltung beschrieben werden können.

Somit sind die Ergebnisse einer Schaltungssimulation, die auf Logikebene erfolgt, für gewisse Anwendungen unsicher und ungenau, da auch ein genauer Zeitverlauf der elektrischen Signale, der in der elektrischen Schaltung auftritt, nicht berücksichtigt werden kann.

Ferner ist eine Beschreibung der einzelnen Gatter für die Schaltungssimulation erforderlich, die erst ermittelt werden muß, bevor das Verfahren durchgeführt werden kann.

Eine Übersicht über verschiedene Partitionierungsvorschriften ist in [5] zu finden.

Ein parallelisiertes Verfahren zum Clustern einer elektrischen Schaltung nach dem sogenannten Bottom-Up-Prinzip ist aus [6] bekannt.

Somit liegt dem Verfahren das Problem zugrunde, ein Verfahren zur Partitionierung einer elektrischen Schaltung anzugeben, welches direkt die Elemente der elektrischen Schaltung auf Transistorebene berücksichtigt.

Das Problem wird durch das Verfahren gemäß Patentanspruch 1 gelöst.

Bei dem Verfahren wird die elektrische Schaltung auf einen Graphen abgebildet, der die gleiche Topologie wie die elektrische Schaltung aufweist. Die Kanten des Graphen werden mit Gewichtswerten gewichtet, die einen ungefähr erforderlichen Rechenaufwand zur Ermittlung elektrischer Beschreibungsgrößen für das jeweils durch die Kante repräsentierte Element der elektrischen Schaltung beschreiben. Eine Partition wird für die elektrische Schaltung in dem Graphen gebildet, indem zu Beginn des Verfahrens solange miteinander gekoppelte Kanten zu der Partition zusammengefaßt werden, bis die Summe der Gewichtswerte der zusammengefaßten Kanten größer ist als ein erster vorgebbarer Schwellenwert. Ist der erste Schwellenwert erreicht, wird jeweils die Partition dann um weitere restliche Kanten erweitert, wenn die Summe der Gewichtswerte aller Kanten, inklusive der neu eventuell hinzuzufügenden Kanten kleiner ist als ein vorgebbarer zweiter Schwellenwert und wenn die Anzahl von Kanten der Partition, die mit Knoten verbunden sind, die nicht innerhalb der Partition liegen, durch Hinzunahme der mindestens einen neuen Kante verringert wird.

Das Verfahren weist einige erhebliche Vorteile gegenüber dem aus dem Dokument [4] bekannten Verfahren auf.

Da das Verfahren direkt auf der Transistorebene der elektrischen Schaltung arbeitet, sind die durch das Verfahren erzielten Ergebnisse bei einer späteren Schaltungssimulation unter Verwendung der auf die erfindungsgemäß ermittelten Partitionen erheblich genauer und verläßlicher.

Vorteilhafte Weiterbildungen der Erfindung ergeben sich aus den abhängigen Ansprüchen.

Es ist vorteilhaft, für vorgebbare Elemente der elektrischen Schaltung zu Beginn des Verfahrens festzulegen, daß die Elemente gemeinsam in eine Partition gruppiert werden. Durch diese Weiterbildung des Verfahrens wird es möglich sicherzustellen, daß beispielsweise bei gesteuerten Quellen sowohl die steuernden Elemente als auch die gesteuerte Quelle gemeinsam in einer Partition bearbeitet werden können. Ebenso ist es durch diese Weiterbildung möglich, Verbindungsschleifen in der elektrischen Schaltung, die lediglich mindestens eine Spannungsquelle und/oder mindestens eine Induktivität aufweisen, ebenso gemeinsam in einer Partition anzuordnen. Ferner wird es durch diese Vorgehensweise möglich, möglicherweise durch die Partitionierung entstehende Kurzschlüsse zu vermeiden.

Durch die Weiterbildung des Verfahrens, daß mehreren Kanten des Graphen ein gemeinsamer Gewichtswert zugeordnet wird, wird die Durchführung des Verfahrens durch einen Rechner weiter beschleunigt, da bei dieser Weiterbildung eine geringere Anzahl von Gewichtswerten im Rahmen des Verfahrens berücksichtigt werden müssen.

Ferner ist es vorteilhaft, mehrere Partitionen für die elektrische Schaltung zu bilden, für die Partitionen die entsprechenden Graphen der Partitionen wieder auf die elektrische Schaltung abzubilden und die entstehenden Partitionen der elektrischen Schaltung parallel auf verschiedenen Rechnern bzw. Prozessoren zu verarbeiten. Durch diese Parallelisierung wird eine Schaltungssimulation einer sehr großen Schaltung erheblich schneller durchführbar, als es bei einer rein "seriellen" Schaltungssimulation möglich ist.

Ferner ist es vorteilhaft, bei der parallelisierten Schaltungssimulation die Verarbeitung der einzelnen Partitionen zentral zu steuern. Auf diese Weise wird eine geregelte Schaltungssimulation mit möglichst geringem Kommunikationsaufwand realisiert.

Ferner ist es vorteilhaft, den einzelnen Anschlüssen der Partitionen, die mit Komponenten, die nicht in der Partition liegen, gekoppelt sind, zusätzlich mit einer Spannungsquelle und einem Wiederstand zu versehen, wobei der Spannungsquelle jeweils von einer zentralen Steuereinheit, die die parallelisierte Bearbeitung der Partitionen steuert, die elektrischen Randbeschreibungsgrößen zugewiesen werden. Durch den Widerstand, der jeweils in den Anschlüssen vorgesehen ist, wird die Konvergenz der Schaltungssimulation während der parallelisierten Schaltungssimulation gewährleistet, deren Wert durch die Steuereinheit dynamisch angepaßt wird.

In den Figuren ist ein Ausführungsbeispiel des Verfahrens dargestellt, welches im weiteren näher erläutert wird.

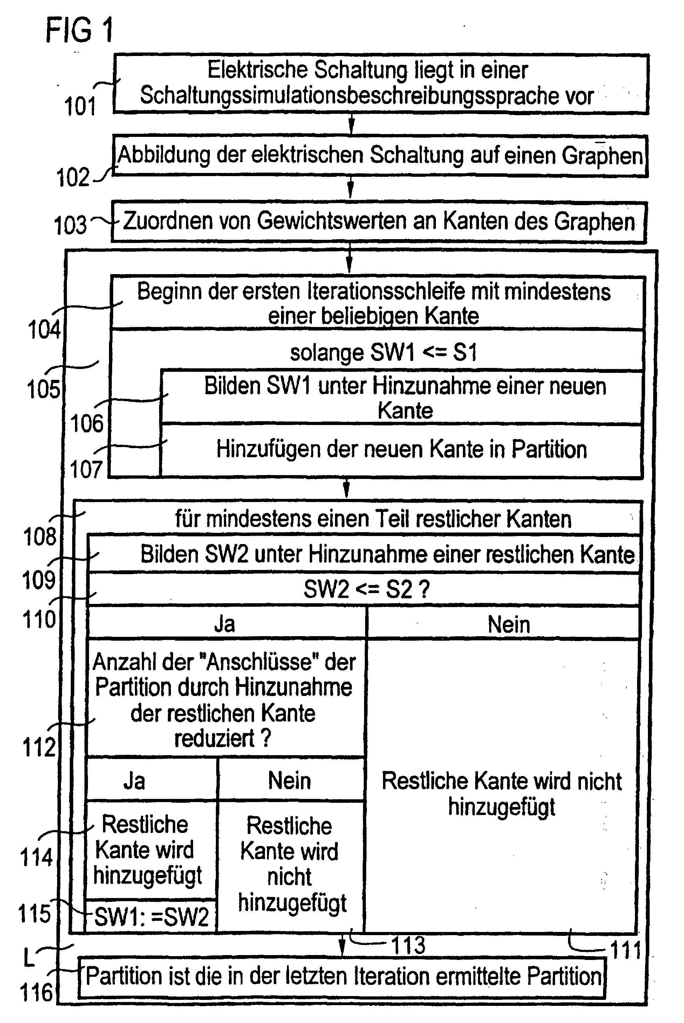

Es zeigen
- Fig. 1: ein Ablaufdiagramm, in dem die einzelnen Verfahrensschritte des Verfahrens dargestellt sind;
- Fig. 2: ein Skizze, in der verschiedene Weiterbildungen des Verfahrens dargestellt sind.

Elektrische Schaltungen, die eine sehr große Anzahl von Elementen aufweisen, können durch Aufteilung der Elemente, d.h. Partitionierung der Elemente in eine beliebige Anzahl von Partitionen und eine Bearbeitung der einzelnen Partitionen auf verschiedenen Rechnern bzw. Prozessoren, die eine Schaltungssimulation durchführen, parallelisiert werden. Damit kann die Durchführung der gesamten Schaltungssimulation erheblich beschleunigt werden.

Damit jedoch die Parallelisierung möglichst optimal ausgestaltet ist, müssen die einzelnen Partitionen sorgfältig bestimmt werden.

Dabei ist es wichtig, zum einen auf eine ungefähr einheitliche Größe der Partition zu achten und zum anderen darauf zu achten, daß die einzelnen Partitionen keine zu große Anzahl von Anschlüssen "nach außen", beispielsweise Kopplungen mit mit anderen, nicht in der Partition liegenden Elementen aufweisen.

Elektrische Schaltungen liegen zur Bearbeitung im Rahmen einer Schaltungssimulation durch einen Rechner üblicherweise in einer Schaltungsbeschreibungssprache vor 101, beispielsweise in der sog. Sprache SPICE, welche in dem Dokument [1] beschrieben ist.

Das Verfahren ist jedoch in keinster Weise auf eine Beschreibung der elektrischen Schaltung in einer Schaltungsbeschreibungssprache und ebenso wenig auf die Verwendung der speziellen Schaltungsbeschreibungssprache SPICE beschränkt.

In einem ersten Verfahrensschritt 102 wird die elektrische Schaltung auf einem Graphen abgebildet, der die gleiche Topologie aufweist wie die elektrische Schaltung. Dies erfolgt beispielsweise ausgehend von der in der Schaltungsbeschreibungssprache SPICE vorliegenden elektrischen Schaltung. Der Graph weist entsprechend der Topologie der elektrischen Schaltung die entsprechenden Knoten auf. Die einzelnen Elemente der elektrischen Schaltung werden durch Kanten zwischen den Knoten des Graphen repräsentiert.

In einer Weiterbildung des Verfahrens ist es vorteilhaft, zu Beginn des Verfahrens einzelne Elemente der elektrischen Schaltung zu markieren, d.h. für die entsprechenden markierten Elemente festzulegen, daß die markierten Elemente im weiteren Verfahren jeweils gemeinsam einer Partition zugeordnet werden. Es können verschiedene Markierungen verschiedene Elemente zu unterschiedlichen Partitionen zuweisen. Es ist auch vorgesehen, Elemente lediglich in einer Weise zu markieren, die derart von dem Rechner, der das Verfahren durchführt, interpretiert wird, daß die jeweils paarweisen Elemente einer Partition zugeordnet werden.

Dabei ist es vorteilhaft, beispielsweise folgende Spezialfälle einer elektrischen Schaltung zu berücksichtigen. Enthält eine elektrische Schaltung gesteuerte Quellen, beispielsweise gesteuerte Stromquellen oder gesteuerte Spannungsquellen, so ist es vorteilhaft, daß sowohl die steuernden Elemente als auch die gesteuerte Quelle für die spätere Schaltungssimulation gemeinsam in einer Partition enthalten sind.

Ferner ist es vorteilhaft, gekoppelte Induktivitäten ebenso jeweils einer gemeinsamen Partition zuzuordnen. Auch ist es wichtig, in einer Weiterbildung des Verfahrens zu berücksichtigen, daß durch die Partitionierung und deren algorithmische Verarbeitung mittels eines Rechners keinerlei Kurzschlüsse auftreten dürfen.

In einem weiteren Schritt 103 werden den Kanten Gewichtswerte G zugeordnet. Mit den Gewichtswerten G wird beschrieben, welcher Rechenaufwand ungefähr zur Ermittlung von elektrischen Beschreibungsgrößen für das jeweilige Element der elektrischen Schaltung, welches durch die Kante repräsentiert wird, der der Gewichtswert G jeweils zugewiesen wird, zu erwarten ist.

Ein Maß für den benötigten Rechenaufwand ist beispielsweise in der Anzahl der Codezeilen zu sehen, der zur Ermittlung der elektrischen Beschreibungsgrößen für das jeweils spezifische Element im Rahmen der Schaltungssimulation benötigt wird. Als groben Maßstab ist hier anzumerken, daß die Ermittlung der elektrischen Beschreibungsgrößen für Transistoren erheblich größer ist als der Aufwand zur Ermittlung der elektrischen Beschreibungsgrößen für einen elektrischen Widerstand oder auch für eine Kapazität. Die Wahl der Gewichtswerte G ist jedoch äußerst unkritisch und stellt lediglich ein ungefähres Größenverhältnis des benötigten Rechenaufwandes dar. Es ist sogar ausreichend, beispielsweise einer Kante, die einen Transistor repräsentiert, einen hohen Gewichtswert G, z. B. den Gewichtswert G = 300 zuzuordnen und den Kanten, die einen Widerstand oder eine Kapazität repräsentieren, einen kleinen Gewichtswert, beispielsweise einen Gewichtswert G = 1 oder sogar einen Gewichtswert G = 0.

Unter elektrischen Beschreibungsgrößen sind in diesem Zusammenhang z. B. die entsprechenden Ströme und Spannungen eines Elementes der elektrischen Schaltung zu verstehen.

Eine im Anschluß durchgeführte erste Iterationsschleife enthält folgende Verfahrensschritte.

Es wird zu Beginn der ersten Iterationsschleife eine beliebige Kante des Graphen ausgewählt 104. Es ist jedoch ebenso in einer Variante des Verfahrens vorgesehen, in diesem Verfahrensschritt eine beliebige Anzahl miteinander gekoppelter Kanten des Graphen auszuwählen, wodurch die Anzahl der benötigten Iterationen in der ersten Iterationsschleife 105, 106, 107 erheblich reduziert wird. Zwei im weiteren beschriebene Verfahrensschritte 106, 107 werden ausgehend von der ausgewählten Kante bzw. ausgenend von der Menge ausgewählter Kanten solange durchgeführt, bis ein erster Summenwert SW1 größer ist als ein frei vorgebbarer ersten Schwellenwert S1.

Es wird für jeweils mindestens eine neue Kante, welche in der Menge berücksichtigter Kanten aus der letzten Iteration nicht enthalten war bzw. die zu Beginn der ersten Iterationsschleife in der ausgewählten Menge von Kanten nicht enthalten war, der erste Summenwert SW1 gebildet. Der erste Summenwert SW1 wird beispielsweise durch Summation der Gewichtswerte G all der Kanten gebildet, die zur Bildung des ersten Summenwerts SW1 herangezogen werden 106.

Ist der erste Summenwert SW1 nicht größer als der erste Schwellenwert S1, ergibt sich eine Partition der elektrischen Schaltung aus den Kanten, die zur Bildung des ersten Summenwerts SW1 herangezogen wurden 107 und die Verfahrensschritte der ersten Iterationsschleife werden erneut, nunmehr mit der "neuen" Partition, durchgeführt.

Ist jedoch der erste Summenwert SW1 größer als der erste Schwellenwert S1, so wird die in dem zeitlich vorangegangenen Iterationsschritt gebildete Partition verwendet und es werden für die gebildete Partition Verfahrensschritte einer weiteren, zweiten Iterationsschleife durchgeführt.

Ausgehend von der jeweiligen Partition werden in jedem Iterationsschritt der zweiten Iterationsschleife folgende Verfahrensschritte für mindestens einen Teil von restlichen Kanten der elektrischen Schaltung durchgeführt 108. Unter einer restlichen Kanten ist in diesem Zusammenhang eine Kante zu verstehen, die nicht schon in der Partition selbst enthalten ist, und die mit einer Kante, welche in der Partition enthalten ist, gekoppelt ist, beispielsweise über einen Knoten in der Partition.

Es wird aus den Gewichtswerten der Partition und den Gewichtswerten von mindestens einer zusätzlichen restlichen Kante ein zweiter Summenwert SW2 gebildet 109. Dies erfolgt beispielsweise wiederum durch einfache Summation über die den entsprechenden Kanten zugeordneten Gewichtswerte G.

Nunmehr wird überprüft, ob der gebildete zweite Summenwert SW2 größer ist als ein frei vorgebbarer zweiter Schwellenwert S2, der größer ist als der erste Schwellenwert S1 110.

Ist der zweite Summenwert SW2 größer als der zweite Schwellenwert S2, so bedeutet dies, daß die Partition größer ist als ein vorgebbarer tolerierter Bereich. Durch den ersten Schwellenwert S1 und dem zweiten Schwellenwert S2 wird somit ein Toleranzbereich für die Größe bzw. für den maximalen tolerierbaren benötigten Bearbeitungsaufwand bei der Schaltungssimulation der jeweiligen Partition beschrieben.

Ist also der zweite Summenwert SW2 größer als der zweite Schwellenwert S2, so wird die entsprechende Kante nicht der Partition hinzugefügt 111.

Ist jedoch der zweite Summenwert SW2 nicht größer als der zweite Schwellenwert S2, so wird ferner für die mindestens eine restliche Kante überprüft, ob eine Anzahl von Kanten, die bei der Bildung des zweiten Summenwerts SW2 berücksichtigt wurden, welche mit Kanten gekoppelt sind, die bei der Bildung des zweiten Summenwerts SW2 nicht berücksichtigt wurden, kleiner ist als eine Anzahl von Kanten der Partition, die mit den restlichen Kanten gekoppelt sind 112.

Dieser Vergleich entspricht anschaulich der Anzahl von "Schnittstellen" jeder Partition mit einer anderen Partition bzw. mit einer im weiteren beschriebenen Zentralsteuereinheit oder auch mit einem weiteren, nicht in einer Partition enthaltenen Element der elektrischen Schaltung.

Wird also, anschaulich die Zahl der Anschlüsse für jede Partition durch Hinzufügen der mindestens einen restlichen Kante größer als die schon zuvor bestehende Anzahl von Anschlüssen der Partition, so wird die entsprechende Kante nicht hinzugefügt 113. Ist jedoch die neue Anzahl der Anschlüsse reduziert worden, so wird die entsprechende restliche Kante der Partition hinzugefügt 114. Ferner wird für diesen Fall der erste Summenwert SW1 für die nächste Iteration der zweiten Iterationsschleife mit dem Wert des zweiten Summenwertes SW2 belegt.

Die zweite Iterationsschleife wird für eine beliebig vorgebbare Anzahl von restlichen Kanten durchgeführt. Es ist in einer Weiterbildung des Verfahrens ebenso vorgesehen, als Abbruchskriterium für die zweite Iterationsschleife einfach die Information zu verwenden, ob alle restlichen Kanten in der zweiten Iterationsschleife berücksichtigt wurden. Ist dies der Fall, so wird bei dieser Weiterbildung die zweite Iterationsschleife beendet. Nach Abbruch bzw. Beendigung der zweiten Iterationsschleife wird die Partition, die in der letzten Iteration der zweiten Iterationsschleife gebildet wurde, als Partition der elektrischen Schaltung verwendet 116.

Unter Verwendung der ursprünglichen Beschreibung der elektrischen Schaltung, beispielsweise in der Schaltungsbeschreibungssprache SPICE wird die Partition in eine für den Rechner weiter zu verarbeitende Syntax, beispielsweise wiederum in die Schaltungsbeschreibungssprache SPICE abgebildet. Bei dieser Abbildung wird die Information der jeweiligen Partition für das jeweilige Element der elektrischen Schaltung beispielsweise durch Markierung des jeweiligen Elementes berücksichtigt.

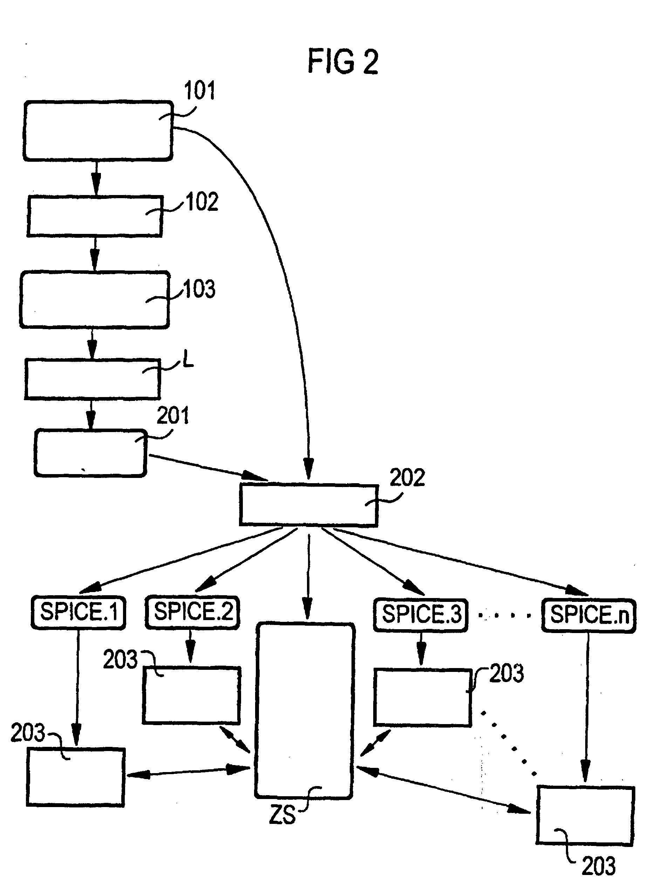

Durch diese Rückabbildung 201 (vgl. Figur 2) entsteht also wiederum für den Spezialfall der Verwendung der Schaltungsbeschreibungssprache SPICE eine Liste mit den Schaltungselementen der elektrischen Schaltung sowie mit den Kopplungen und der jeweiligen Angabe der Partition, der das jeweilige Element zugeordnet wurde.

In einer Weiterbildung des Verfahrens ist es vorteilhaft, dieses Verfahren für eine beliebige Zahl von Partitionen durchzuführen, d.h. die elektrische Schaltung wird in eine beliebige Anzahl von Partitionen unterteilt. Bei dieser Weiterbildung entstehen entsprechend der Anzahl gebildeter Partitionen partitionsspezifische Listen mit den Elementen der elektrischen Schaltung in der Schaltungsbeschreibungssprache SPICE 202. Eine in einer Weiterbildung des Verfahrens vorteilhafte Parallelisierung der Schaltungssimulation der elektrischen Schaltung wird nunmehr dadurch erreicht, daß die elektrischen Beschreibungsgrößen für die Elemente der elektrischen Schaltung für jede Partition separat ermittelt werden, wobei mindestens ein Teil der Partitionen parallel auf mehreren Rechnern und/oder Prozessoren bearbeitet werden kann. Dies entspricht einer Parallelisierung der Schaltungssimulation.

In einer Weiterbildung des Verfahrens ist es ferner vorgesehen, mehreren Kanten des Graphen einen gemeinsamen Gewichtswert zuzuordnen. Durch diese Vorgehensweise wird der benötigte Rechenaufwand reduziert.

Verfahren zur parallelisierten Schaltungssimulation auf verteilten Prozessoren, bzw. verteilten Rechnern sind beispielsweise aus dem Dokument [2] und [3] bekannt. Diese können ohne Einschränkung auf die durch das Verfahren gebildeten Partitionen angewendet werden.

Ferner ist es in einer Weiterbildung des Verfahrens vorgesehen, die parallele Verarbeitung der Partitionen über eine zentrale Steuereinheit ZS zentral zu steuern. Dies bedeutet beispielsweise, daß die Kommunikation der einzelnen Partitionen in dem Verfahren der Schaltungssimulation, wie sie in den Dokumenten [2] und [3] beschrieben ist, d.h. die Übermittlung von Daten lediglich zwischen der zentralen Steuereinheit ZS und dem Teil der Partitionen erfolgt, der zentral gesteuert wird.

In Fig. 2 ist die parallelisierte Verarbeitung durch eine Vielzahl von SPICE-Dateien SPICE.1, SPICE.2, SPICE.3 bis SPICE.N symbolisch dargestellt. In diesen SPICE-Dateien sind die einzelnen Beschreibungen der Partitionen in der Schaltungsbeschreibungssprache SPICE enthalten.

Es wird für die jeweilige Partition eine Schaltungsimulation durchgeführt 203, beispielsweise zentral gesteuert von der zentralen Steuereinheit ZS.

Ferner ist es in einer Weiterbildung des Verfahrens vorgesehen, mindestens einen Teil der Anschlüsse der jeweiligen Partition, welche im Rahmen der parallelisierten Schaltungssimulation bearbeitet wird, zusätzlich eine Spannungsquelle zuzuweisen, welcher jeweils im Rahmen der bekannten Verfahren von der zentralen Steuereinheit ZS ein entsprechender Wert zugewiesen wird. Zur Gewährleistung der Konvergenz des iterativen Verfahrens aus dem Dokument [2] und [3] ist es vorteilhaft, zumindest bei einem Teil der Anschlüsse der jeweiligen Partitionen zusätzlich einen Widerstand vorzusehen, dessen Wert von der Steuereinheit ZS dynamisch angepaßt wird.

Im Rahmen dieses Dokumentes wurden folgende Veröffentlichungen zitiert:
[1] I. Hoefer, H. Nielinger, SPICE Analyseprogramm für elektronische Schaltungen, Springer Verlag, Berlin, B, ISBN 3-540-15160-5, S. 7 bis 22, 1985
[2] U. Wever, Q. Zheng et al, Domain Decomposition Methods for Circuit Simulation, Proceedings of the 8th Workshop on Parallel and Distributed Simulation, PADS 94 Edinburgh, Scotland, UK, ZS, S. 183-186, Juli 1994
[3] U. Wever & Q. Zheng, Parallel Transient Analysis for Circuit Simulation, Proceedings of the 29th Annual Hawaii International Conference on System Sciences, ZS, S. 442 bis 447, 1996
[4] B. Riess et al, Partitioning Very Large Circuits Using Analytical Placement Techniques, Proceedings of the 31st ACM/IEEE Design Autmation Conference, S. 646 bis 651, 1994
[5] F. Johannes, Partitioning of VLSI Circuits and Systems, 33rd Design Automation Conference, 3. - 7. Juni, Las Vegas, S. 83 - 87, 1996
[6] J. Cong et al, A Parallel Bottom-Up Clustering Algorithm with Applications to Circuit Partitioning in VLSI Design, In: 30rd Design Automation Conference, 14. - 18. Juni, Dallas, S. 755 - 760, 1993

## Patentansprüche

1. Rechnergestütztes Verfahren zur Partitionierung einer elektrischen Schaltung,
- bei dem die elektrische Schaltung auf einen Graphen abgebildet wird, der die gleiche Topologie aufweist wie die elektrische Schaltung,
- bei dem Kanten des Graphen Gewichtswerte zugeordnet werden, mit denen ein erforderlicher Rechenaufwand zur Ermittlung von elektrischen Beschreibungsgrößen für Elemente der elektrischen Schaltung, die durch die jeweilige Kante repräsentiert werden, beschrieben wird,
- bei dem für miteinander gekoppelte Kanten ein erster Summenwert der Gewichtswerte der Kanten ermittelt wird, und in weiteren Iterationen jeweils der erste Summenwert gebildet wird unter Hinzufügen mindestens einer weiteren Kante, bis der jeweils ermittelte erste Summenwert größer ist als ein vorgebbarer erster Schwellenwert,
- bei dem durch die bei der Bildung des ersten Summenwerts berücksichtigten Kanten eine Partition der elektrischen Schaltung gebildet wird,
- bei dem für mindestens einen Teil der restlichen Kanten, die nicht in der Partition liegen und die mit mindestens einer Kante der Partition gekoppelt sind, folgende Schritte durchgeführt werden:
-- es wird ein zweiter Summenwert bestimmt, der sich aus der Summe des ersten Summenwerts und mindestens einem Gewichtswert mindestens einer restlichen Kante ergibt,
-- ist der zweite Summenwert kleiner als ein vorgebbarer zweiter Schwellenwert, und
-- ist eine Anzahl von Kanten, die bei der Bildung des zweiten Summenwerts berücksichtigt wurden, die mit Kanten gekoppelt sind, die bei der Bildung des zweiten Summenwerts nicht berücksichtigt wurden, kleiner als eine Anzahl von Kanten der Partition, die mit den restlichen Kanten gekoppelt sind, dann
-- wird die restliche Kante der Partition zugeordnet und dem ersten Summenwert wird der zweite Summenwert zugeordnet, und
- bei dem die Partition durch die bei der Bildung des zweiten Summenwerts berücksichtigten Kanten gebildet wird.

2. Verfahren nach Anspruch 1,
bei dem zu Beginn des Verfahrens eine Gruppierung von Elementen der elektrischen Schaltung durchgeführt wird, für die jeweils festgelegt wird, daß diese Elemente gemeinsam einer Partition zugeordnet werden.

3. Verfahren nach Anspruch 2,
bei dem bei der Gruppierung der Elemente der elektrischen Schaltung mindestens eine der folgenden Vorschriften angewendet wird:
- Elemente einer gesteuerten Quelle, mindestens ein steuerndes Element und die gesteuerte Quelle, werden in gemeinsam einer Partition zugeordnet,
- Verbindungsschleifen in der elektrischen Schaltung, die nur mindestens eine Spannungsquelle und mindestens eine Gegeninduktivität enthalten, werden in gemeinsam einer Partition zugeordnet,
- es dürfen keine Kurzschlüsse durch die Partitionierung entstehen.

4. Verfahren nach einem der Ansprüche 1 bis 3,
bei dem mehreren Kanten des Graphen ein gemeinsamer Gewichtswert zugeordnet wird.

5. Verfahren nach einem der Ansprüche 1 bis 4,
bei dem der Graph der Partition abgebildet wird auf die elektrische Schaltung, wobei die Partition die Elemente der elektrischen Schaltung aufweist entsprechend der durchgeführten Partitionierung.

6. Verfahren nach einem der Ansprüche 1 bis 5,
- bei dem mehrere Partitionen durch mehrfache Durchführung des Verfahrens gebildet werden, und
- bei dem die elektrischen Beschreibungsgrößen für die Elemente der elektrischen Schaltung für jede Partition ermittelt werden, wobei mindestens ein Teil der Partitionen parallel auf mehreren Rechnern und/oder Prozessoren bearbeitet wird.

7. Verfahren nach Anspruch 6,
bei dem die parallele Verarbeitung der Partitionen zentral gesteuert wird.

8. Verfahren nach Anspruch 7,
bei dem mindestens ein Teil der Partitionen in einer Weise zentral gesteuert werden, daß alle Anschlüsse der jeweiligen Partition nur mit einer zentralen Steuereinheit gekoppelt sind und somit eine Übermittlung von Daten nur zwischen der zentralen Steuereinheit und mindestens dem Teil der Partitionen erfolgt.

9. Verfahren nach Anspruch 8,
bei dem mindestens einem Teil der Anschlüsse der jeweiligen Partition zusätzlich eine Spannungsquelle zugewiesen wird, deren Wert während der Ermittlung der elektrischen Beschreibungsgrößen von der zentralen Steuereinheit vorgegeben wird.

10. Verfahren nach Anspruch 9,
bei dem mindestens einem Teil der Anschlüsse der jeweiligen Partition zusätzlich ein Widerstand zugewiesen wird.

## Revendications

1. Procédé assisté par ordinateur pour la segmentation d'un circuit électrique,
- dans lequel le circuit électrique est projeté sur un graphe, qui présente la même topologie que le circuit électrique,
- dans lequel sont affectées à l'arête du graphe des valeurs de pondération qui décrivent le coût de calcul nécessaire pour la détermination des grandeurs électriques équivalentes pour des éléments de circuit électrique qui sont représentées par l'arête respective,
- dans lequel, pour des arêtes couplées l'une à l'autre, on détermine une première valeur de sommation des valeurs de pondération des arêtes et, dans d'autres itérations, on forme respectivement la première valeur de sommation par addition d'au moins une autre arête jusqu'à ce que la première valeur de sommation respectivement déterminée soit plus grande qu'une première valeur de seuil prédéterminée,
- dans lequel un segment du circuit électrique est formé par les arêtes prises en compte pour la formation de la première valeur de sommation,
- dans lequel les étapes suivantes sont réalisées pour au moins une partie des arêtes restantes, qui ne se trouvent pas dans le segment et qui sont couplées à au moins une arête du segment :
○ on détermine une seconde valeur de sommation, qui s'obtient à partir de la somme de la première valeur de sommation et d'au moins une valeur de pondération d'au moins une arête restante,
○ si la seconde valeur de sommation est plus petite qu'une seconde valeur de seuil prédéterminée, et
○ si le nombre d'arêtes, qui ont été prises en compte lors de la formation de la seconde valeur de sommation et qui sont couplées avec des arêtes qui n'ont pas été prises en compte dans la formation de la seconde valeur de sommation, est plus petit que le nombre d'arêtes du segment qui sont couplés avec les arêtes restantes,
○ l'arête restante est affectée au segment et la seconde valeur de sommation est affectée à la première valeur de sommation, et
- dans lequel le segment est formé par les arêtes prises en compte lors de la formation de la seconde valeur de sommation.

2. Procédé selon la revendication 1, dans lequel, au début du procédé, on effectue un groupage d'éléments du circuit électrique pour lesquels il est établi respectivement que ces éléments sont affectés conjointement à un segment.

3. Procédé selon la revendication 2, dans lequel, lors du groupage des éléments du circuit électrique, au moins l'une des prescriptions suivantes est appliquée :
- les éléments d'une source commandée, au moins un élément de commande et la source commandée, sont affectés conjointement à un segment,
- des boucles de connexion du circuit électrique, qui ne contiennent au moins qu'une source de tension et au moins une contre-inductance, sont affectées conjointement à un segment,
- il ne peut se produire de courts-circuits du fait de la segmentation.

4. Procédé selon l'une quelconque des revendications 1 à 3, dans lequel une valeur de pondération commune est affectée à plusieurs arêtes du graphe.

5. Procédé selon l'une quelconque des revendications 1 à 4, dans lequel le graphe du segment est projeté sur le circuit électrique de sorte que le segment présente les éléments du circuit électrique en fonction de la segmentation réalisée.

6. Procédé selon l'une quelconque des revendications 1 à 5,
- dans lequel plusieurs segments sont formés par réalisation multiple du procédé, et
- dans lequel les grandeurs électriques équivalentes pour les éléments de circuit électrique sont déterminées pour chaque segment, au moins une partie des segments étant traitée en parallèle sur plusieurs ordinateurs et/ou processeurs.

7. Procédé selon la revendication 6, dans lequel le traitement en parallèle des segments est commandé de manière centralisée.

8. Procédé selon la revendication 7, dans lequel au moins une partie des segments est commandée de manière centralisée afin que toutes les connexions du segment respectif ne soit couplées qu'avec une unité de commande centrale et que, de la sorte, il se fasse un transfert de données uniquement entre l'unité de commande centrale et au moins la partie des segments.

9. Procédé selon la revendication 8, dans lequel on affecte en outre à au moins une partie des connexions du segment respectif une source de tension, dont la valeur est prédéterminée par l'unité de commande centrale au cours de la détermination des grandeurs électriques équivalentes.

10. Procédé selon la revendication 9, dans lequel on affecte en outre une résistance à au moins une partie des connexions du segment respectif.

## Claims

1. Computer-aided method for partitioning an electric circuit,
- in which the electric circuit is mapped onto a graph which has the same topology as the electric circuit,
- in which weighting values are assigned to the lines of the graph, said weighting values describing the computing effort required for determining electric description variables for elements of the electric circuit which are represented by the relevant line,
- in which a first sum value for the weighting values of the lines is determined for lines which are linked together, and the first sum value is formed in each subsequent iteration by adding at least one further line until the first sum value determined at the time is greater than a presettable first threshold value,
- in which a partition of the electric circuit is formed by the lines taken into consideration when forming the first sum value,
- in which the following steps are carried out for at least some of the remaining lines, which lines are not located in the partition and are linked to at least one line of the partition:
-- a second sum value is determined, said value being derived from the sum of the first sum value and at least one weighting value for at least one remaining line,
-- if the second sum value is smaller than a presettable second threshold value, and
-- if a number of lines which were taken into consideration when forming the second sum value, which lines are linked to lines that were not taken into consideration when forming the second sum value, is smaller than a number of lines of the partition which are linked to the remaining lines, then
-- the remaining line is assigned to the partition and the second sum value is assigned to the first sum value, and
- in which the partition is formed by the lines taken into consideration when forming the second sum value.

2. Method according to Claim 1,
in which elements in the electric circuit are grouped at the beginning of the method, specifying in each case that these elements are assigned jointly to a partition.

3. Method according to Claim 2,
in which at least one of the following rules is applied when grouping the elements of the electric circuit:
- elements of a controlled source, at least one controlling element and the controlled source, are assigned jointly to a partition,
- connection loops in the electric circuit which only contain at least one voltage source and at least one mutual inductance are assigned jointly to a partition,
- the partitioning must not result in any short circuits.

4. Method according to one of Claims 1 to 3,
in which a common weighting value is assigned to a plurality of lines of the graph.

5. Method according to one of Claims 1 to 4,
in which the graph of the partition is mapped onto the electric circuit, said partition having the elements of the electric circuit in accordance with the partitioning carried out.

6. Method according to one of Claims 1 to 5,
- in which a plurality of partitions is formed by multiple execution of the method, and
- in which the electric description variables for the elements of the electric circuit are determined for each partition, at least some of the partitions being processed in parallel on a plurality of computers and/or processors.

7. Method according to Claim 6,
in which the parallel processing of the partitions is controlled centrally.

8. Method according to Claim 7,
in which at least some of the partitions are controlled centrally in such a way that all interfaces of the partition concerned are linked only to a central controller, and therefore transmission of data only takes place between the central controller and at least those partitions.

9. Method according to Claim 8,
in which at least some of the interfaces of the partition concerned are additionally assigned a voltage source, the value of said voltage source being preset by the central controller during determination of the electric description variables.

10. Method according to Claim 9,
in which at least some of the interfaces of the partition concerned are additionally assigned a resistance.
